Europäisches Patentamt

European Patent Office

Office européen des brevets

(19)

(11) Veröffentlichungsnummer: **0 202 347**
**B1**

(12) # EUROPÄISCHE PATENTSCHRIFT

(45) Veröffentlichungstag der Patentschrift:
**11.05.88**

(51) Int. Cl.⁴: **G 06 F 7/68**

(21) Anmeldenummer: **85106137.4**

(22) Anmeldetag: **18.05.85**

(54) Frequenzteilerschaltung für nichtganze Teilungszahlen nach Art eines Rate-Multipliers.

(43) Veröffentlichungstag der Anmeldung:
**26.11.86 Patentblatt 86/48**

(45) Bekanntmachung des Hinweises auf die Patenterteilung:
**11.05.88 Patentblatt 88/19**

(84) Benannte Vertragsstaaten:
**DE FR NL**

(56) Entgegenhaltungen:
**US - A - 3 603 773**

**IEEE JOURNAL OF SOLID-STATE CIRCUITS, Band SC-18, Nr. 3, Juni 1983, Seiten 267-272, IEEE, New York, US; R.C. DEN DULK et al.: "A versatile CMOS rate multiplier/variable divider"**

(73) Patentinhaber: **Deutsche ITT Industries GmbH, Hans-Bunte-Strasse 19 Postfach 840, D-7800 Freiburg (DE)**

(72) Erfinder: **Mehrgardt, Sönke, Dr., Häglestrasse 26, D-7801 March (DE)**

(74) Vertreter: **Morstadt, Volker, Dipl.-Ing., c/o Deutsche ITT Industries GmbH Patent/Lizenzabteilung Postfach 840 Hans-Bunte-Strasse 19, D-7800 Freiburg/Brsg. (DE)**

## Beschreibung

Die Erfindung betrifft eine Frequenzteilerschaltung für ganze und nichtganze Stellen aufweisende Teilungszahlen nach Art eines Rate-Multipliers mit einem aus einem getakteten Datenregister und einem m-stelligen ersten Addierer bestehenden digitalen ersten Akkumulator, an dessen Eingang ein den nichtganzen Stellen der Teilungszahl entsprechendes m-stelliges erstes Digitalwort und an dessen zweitem Eingang der Ausgang des Datenregisters liegt, dessen Eingang mit dem Ausgang des ersten Addierers verbunden ist, vgl. den Oberbegriff des Anspruchs 1. Eine derartige Anordnung ist in «ESSCIRC '82», Eighth European Solide-State Circuits Conference, Brüssel, 22. bis 24. September 1982, Seiten 145 bis 148 beschrieben.

Die charakteristische Eigenschaft eines Rate-Multipliers besteht bekanntlich darin, dass er aus jeweils p Impulsen des frenquenzzuteilenden Signals q Impulse möglichst gleichverteilt unterdrückt, wobei q kleiner als p ist. Sollen z.B. während 100 Eingangsimpulsen 66 Impulse unterdrückt, also 33 Ausgangsimpulse erzeugt werden, so werden zuerst 32 Ausgangsimpulse im Abstand von 3 Eingangsimpulsen und dann 1 Ausgangsimpuls im Abstand von 4 Eingangsimpulsen erzeugt.

Benutzt man den üblichen Rate-Multiplier innerhalb einer Phasenverriegelungsschaltung, also einer sogenannten PLL-Schleife, um damit ein frequenz- und phasenstabiles Taktsignal zu erzeugen, so entsteht folgendes Problem: Während der im obigen Beispiel angegebenen Dauer von 32 Ausgangsimpulsen im Abstand von jeweils 3 Eingangsimpulsen wird sich die PLL-Schleife bei hierfür geeigneter Zeitkonstante auf den Phasenfehler null einregeln. Für die Dauer der erwähnten vier Eingangsimpulse tritt aber dann ein grosser Phasenfehler (Jitter) auf.

Die Aufgabe der in den Ansprüchen gekennzeichneten Erfindung besteht daher darin, eine Frequenzteilerschaltung anzugeben, die nicht mehr wie ein Rate-Multiplier die zu unterdrückenden Impulse gleichverteilt unterdrückt, sondern sie nach einer für den beispielsweisen Anwendungsfall in PLL-Schleifen besser geeigneten Art und Weise verteilt unterdrückt.

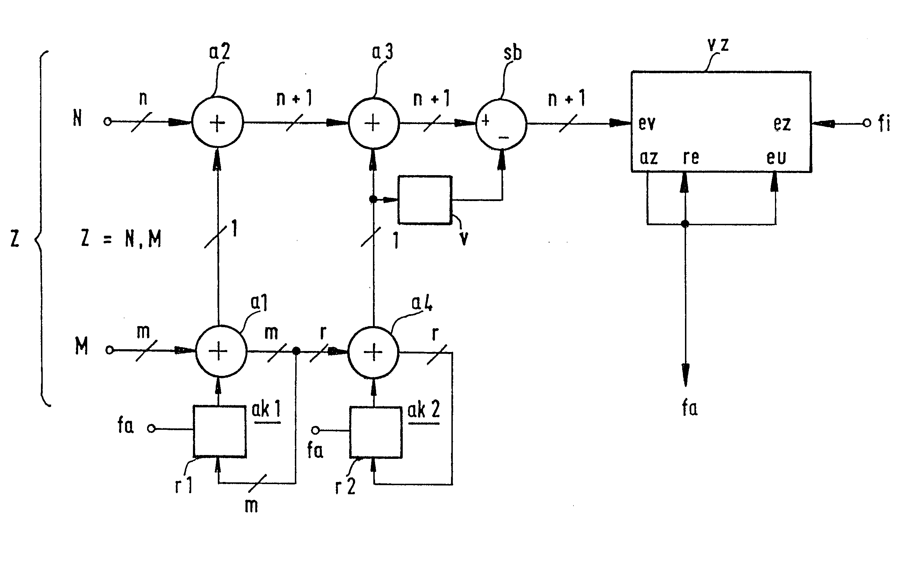

Die Erfindung und ihre Vorteile werden nun anhand der Figur der Zeichnung näher erläutert.

In der Figur ist ein schematisiertes Blockschaltbild eines Ausführungsbeispiels der Erfindung gezeigt. Die ganze und nichtganze Stellen aufweisende Teilungszahl, durch die das frequenzzuteilende Signal fi geteilt werden soll, damit das frequenzgeteilte Signal fa entsteht, — diese Teilungszahl ist also eine rationale Zahl, die grösser/gleich drei sein muss und die für die Zwecke der Erfindung in Kommadarstellung vorliegend gedacht wird —, entspricht dem der Frequenzteilerschaltung zugeführten Digitalwort Z, das aus dem den nichtganzen Stellen der Teilungszahl entsprechenden m-stelligen Digitalwort M und dem den ganzen Stellen der Teilungszahl entsprechenden n-stelligen Digitalwort N besteht, so dass sich wie üblich die Schreibweise Z=N,M ergibt.

Der erste Addierer a1 und das erste Datenregister r1 bilden den digitalen ersten Akkumulator ak1, dessen Eingang mit dem ersten Eingang des Addierers a1 identisch ist. Diesem ist das erste Digitalwort M zugeführt, das in Schritten des das Datenregister taktenden frequenzgeteilten Signals fa akkumuliert wird, da der Ausgang des Addierers a1 mit dem Eingang des Datenregisters r1 verbunden ist und somit dessen Ausgangssignal bei jedem Taktimpuls in das Register übernommen und an den zweiten Eingang des Addierers a1 gelegt wird.

Das zweite Digitalword N ist dem ersten Eingang des n-stelligen zweiten Addierers a2 zugeführt, während an dessen zweitem Eingang der Übertragsausgang des ersten Addierers a1 liegt und an dessen Ausgang der erste Eingang des (n+1)-stelligen dritten Addierers a3 angeschlossen ist.

Signalflussmässig ist dem ersten Akkumulator ak1 der zweite Akkumulator ak2 nachgeschaltet, der aus dem vierten Addierer a4 und dem zweiten Datenregister r2 besteht, das wiederum vom frequenzgeteilten Signal fa getaktet ist. Der vierte Addierer a4 ist r-stellig, wobei für r gilt: $1 \leq r \leq m$ und dessen erstem Eingang r höchstwertige Stellen des Ausgangssignals des ersten Akkumulators ak1 zugeführt sind. Der Übertragsausgang des vierten Addierers a4 liegt am zweiten Eingang des dritten Addierers a3 und über das Verzögerungsglied v am Subtrahend-Eingang des Subtrahierers sb. Die Verzögerungszeit des Verzögerungsglieds v ist dabei gleich der jeweiligen Periodendauer des frequenzgeteilten Signals fa, und am Minuend-Eingang des Subtrahierers sb liegt der Ausgang des dritten Addierers a3.

Der Ausgang des Subtrahierers sb liegt am Vorwahleingang ev des Vorwahlzählers vz, dessen Zähleingang ez das frequenzzuteilende Signal fi zugeführt ist. Das frequenzgeteilte Signal fa tritt an demjenigen Zählerausgang az auf, an dem nach so vielen Impulsen, wie dem am Vorwahleingang ev liegenden Wert entspricht, ein Impuls auftritt. Dieser Zählerausgang az ist sowohl mit dem Reset-Eingang re als auch mit dem Übernahmeeingang eu verbunden, so dass bei jedem an ihm auftretenden Impuls der Zähler vz, sofern er ein Vorwärtszähler ist, zurückgesetzt wird und das dann am Vorwahleingang ev anstehende Digitalwort in den Zähler vz übernommen wird. Wird der Zähler vz dagegen mittels eines Rückwärtszählers realisiert, so ist der Zählerausgang az mit dem Null-Ausgang identisch, so dass auf die Verbindung mit dem Reset-Eingang und/oder auf diesen selbst verzichtet werden kann.

Durch die Hinzufügung des zweiten Akkumulators ak2, der Addierer a2, a3, des Subtrahierers sb und des Vorwahlzählers vz zum Akkumulator ak1 hat die Frequenzteilerschaltung die gewünschte, von der Rate-Multiplier-Eigenschaft abweichende Impulsunterdrückungs-Gesetzmässigkeit, und zwar derart, dass durch die erwähnten zusätzlichen Teilschaltungen sich nunmehr ein Rate-Multiplier mit sogenannter Rauschfärbung ergibt, wobei diese Färbung der Frequenzcharakteristik gegenläufig zu rosa Rauschen ist. Dies bedeutet, dass die Amplitude von tieffrequenten Rauschsignalen gegenüber weissem Rauschen unter Inkaufnahme der Erhöhung von Amplituden höherfrequenter Rauschsignale abgesenkt ist. Bei der bevorzugten Verwendung der erfindungsgemässen Frequenzteilerschaltung in den erwähnten PLL-Schleifen ergibt sich somit an deren Ausgang ein jitterärmeres Signal von hoher Frequenzstabilität und sehr hoher Frequenzeinstellgenauigkeit, da die tieffrequenten Änderungen im frequenzgeteilten Ausgangssignal fa stark reduziert sind.

Die Erfindung lässt sich vorteilhaft mittels monolithisch integrierter Schaltungen realisieren, wobei sie, da sie ausschliesslich aus digitalen Teilschaltungen besteht, insbesondere in Isolierschicht-Feldeffekttransistor-Technik (MOS-Technik) integriert werden kann.

In der Figur ist mittels der Zahlen an den in den Verbindungsleitungen angebrachten Schrägstrichen angedeutet, wie viele Stellen die auf diesen Leitungen laufenden Digitalsignale haben und wie viele Leitungen somit die entsprechenden Busse bei Parallelverarbeitung mindestens aufweisen.

## Patentansprüche

1. Frequenzteilerschaltung für ganze und nichtganze Stellen aufweisende Teilungszahlen nach Art eines Rate-Multipliers mit einem aus einem getakteten Datenregister (r1) und einem m-stelligen ersten Addierer (a1) bestehenden digitalen ersten Akkumulator (ak1), an dessen Eingang ein den nichtganzen Stellen der Teilungszahl entsprechendes m-stelliges erstes Digitalwort (M) und an dessen zweitem Eingang der Ausgang des Datenregisters (r1) liegt, dessen Eingang mit dem Ausgang des ersten Addierers (a1) verbunden ist, *gekennzeichnet durch folgende Merkmale:*

— ein den ganzen Stellen der Teilungszahl entsprechendes n-stelliges zweites Digitalwort (N) liegt am ersten Eingang eines n-stelligen zweiten Addierers (a2), und an dessen zweitem Eingang liegt der Übertragsausgang des ersten Addierers (a1),

— der Ausgang des zweiten Addierers (a2) liegt am ersten Eingang eines (n+1)-stelligen dritten Addierers (a3), und dessen Ausgang liegt am Minuend-Eingang eines Subtrahierers (sb), dessen Ausgang am Vorwahleingang (ev) eines Vorwahlzählers (vz) angeschlossen ist,

— am Zähleingang (ez) des Vorwahlzählers (vz) liegt das frequenzzuteilende Signal (fi), und an dessen Übernahmeeingang (eu) sowie an dessen Reset-Eingang (re) liegt derjenige Zählerausgang (az), an dem nach so vielen Impulsen, wie dem am Vorwahleingang (ev) liegenden Wert entspricht, ein Impuls auftritt, welche Impulse das frequenzgeteilte Signal (fa) sind und die Datenregister (r1, r2) takten, und

— an r höchstwertigen Stellen des Ausgangs des ersten Akkumulators (ak1) liegt der Eingang eines r-stelligen zweiten Akkumulators (ak2), wobei für r gilt $1 \leq r \leq m$, und wobei der Übertragsausgang des zweiten Akkumulators (ak2) am zweiten Eingang des dritten Addierers (a3) und über ein Verzögerungsglied (v), dessen Verzögerungszeit gleich der jeweiligen Periodendauer des frequenzgeteilten Signals (fa) ist, am Subtrahend-Eingang des Subtrahierers (sb) angeschlossen ist.

2. Verwendung der Frequenzteilerschaltung nach Anspruch 1 als einstellbarer Frequenzteiler von Phasenverriegelungsschaltungen (PLL-Schleifen).

## Claims

1. Frequency divider circuit for divisors consisting of an integral part and a fractional part which is designed in the manner of a rate multiplier and comprises a digital first accumulator (ak1) consisting of a clocked data register (r1) and an m-bit first adder (a1) whose first input is presented with an m-bit first digital word (M) corresponding to the fractional part of the divisor, and whose second input is fed from the output of the data register (r1), whose input is connected to the output of the first adder (a1),
*characterized by the following features:*
— an n-bit second digital word (N) corresponding to the integral part of the divisor is fed to the first input of an n-bit second adder (a2) having its second input connected to the carry output of the first adder (a1);
— the output of the second adder (a2) is coupled to the first input of an (n+1)-bit third adder (a3) whose output is connected to the minuend input of a subtracter (sb) having its output coupled to the preset input (ev) of a presettable counter (vz);
— the signal to be frequency-divided (fi) is applied to the count input (ez) of the presettable counter (vz), whose enable input (eu) and reset input (re) are connected to that counter output (az) at which a pulse occurs after a number of pulses equal to the value applied to the preset input (ev), said output pulses being the frequency-divided signal (fa) and clocking the data registers (r1, r2), and
— r most significant output bits of the first accumulator (ak1) are fed to the input of an r-bit second accumulator (ak2), with the following relation holding for r: $1 \leq r \leq m$, and the carry output of the second accumulator (ak2) is coupled to the second input of the third adder (a3) and, through a delay element (v) giving a delay equal to the respective period of the frequency-divided signal (fa), to the subtrahend input of the subtracter (sb).

2. Use of the frequency divider circuit claimed in claim 1 as an adjustable frequency divider in phase-locked loops.

## Revendications

1. Circuit de division de fréquence pour des diviseurs présentant des positions entières et non entières à la manière d'un multiplieur à taux comportant un premier accumulateur numérique (ak1) constitué d'un registre de données (r1) synchronisé et d'un premier additionneur à m positions (a1), à l'entrée duquel est connecté un premier mot numérique (M) à m positions correspondant aux positions non entières du diviseur et à la deuxième entrée duquel est connectée la sortie du registre de données (r1), dont l'entrée est reliée à la sortie du premier additionneur, caractérisé en ce qu'un deuxième mot numérique à n positions (N) correspondant aux positions entières du diviseur est connecté à la première entrée d'un deuxième additionneur à n positions (a2) à la deuxième sortie duquel est connectée la sortie de report du premier additionneur (a1), en ce que la sortie du deuxième additionneur (a2) est connectée à la première entrée d'un troisième additionneur à (n+1) positions (a3) dont la sortie est connectée à l'entrée de diminuende d'un soustracteur (sb), dont la sortie est raccordée à l'entrée de présélection (ev) d'un compteur à présélection (vz), en ce qu'à l'entrée de comptage (ez) du compteur à présélection (vz) est connecté le signal à diviser en fréquence (fi), et qu'à son entrée de transfert (eu) ainsi qu'à son entrée de remise à zéro (re) est connectée la sortie de comptage (az) à laquelle sort une impulsion, après le nombre d'impulsions correspondant à la valeur connectée à l'entrée de présélection (ev), ces impulsions étant le signal divisé en fréquence (fa) et synchronisant les registres de données (r1, r2), en ce qu'aux positions de valeurs élevées r de la sortie du premier accumulateur (ak1) est connectée l'entrée d'un deuxième accumulateur à r positions (ak2), avec $1 \leq r \leq m$, et en ce que la sortie de report du deuxième accumulateur (ak2) est raccordée à la deuxième entrée du troisième additionneur (a3) et, par un élément de retard (v), dont le temps de retard est égal à la durée de la période du signal divisé en fréquence (fa), à l'entrée de soustraction du soustracteur (sb).

2. Utilisation du circuit de division de fréquence selon la revendication 1 sous forme de diviseur de fréquence réglable de circuits à verrouillage de phase (boucles PLL).